# EUROPEAN PATENT SPECIFICATION

(11) **EP 3 796 575 B1**
(45) Date of publication and mention of the grant of the patent: **19.03.2025**
(21) Application number: 19197679.4
(22) Date of filing: 17.09.2019
(51) Int. Cl.: H04B 10/80

(54) **OPTOCOUPLER WITH SIDE-EMITTING ELECTROMAGNETIC RADIATION SOURCE**
OPTOKOPPLER MIT SEITENEMITTIERENDER ELEKTROMAGNETISCHER STRAHLUNGSQUELLE
OPTOCOUPLEUR COMPORTANT UNE SOURCE DE RAYONNEMENT ÉLECTROMAGNÉTIQUE À ÉMISSION LATÉRALE

(43) Date of publication of application: 24.03.2021
(73) Proprietor: Infineon Technologies AG, 85579 Neubiberg (DE)
(72) Inventor: Roth, Alexander, 93197 Zeitlarn (DE)
(74) Representative: Dilg, Haeusler, Schindelmann Patentanwaltsgesellschaft mbH

(56) References cited:
- WO-A1-02/084358
- US-A- 5 574 744
- US-A- 5 753 929
- US-A1- 2005 254 758
- US-A1- 2007 241 343
- US-A1- 2011 235 974
- US-A1- 2012 326 170
- US-A1- 2014 042 344
- US-A1- 2014 119 691
- US-A1- 2021 335 682
- US-B1- 8 260 098

## Description

### Background of the invention

### Field of the invention

The present invention relates to an optocoupler and a method of operating an optocoupler.

### Description of the related art

An optocoupler may be an electronic component that transfers electrical signals between two isolated circuits by using light. For instance, an optocoupler may prevent high voltages from affecting the system receiving the signal. A common type of optocoupler may comprise a light-emitting diode and a phototransistor in the same opaque package.

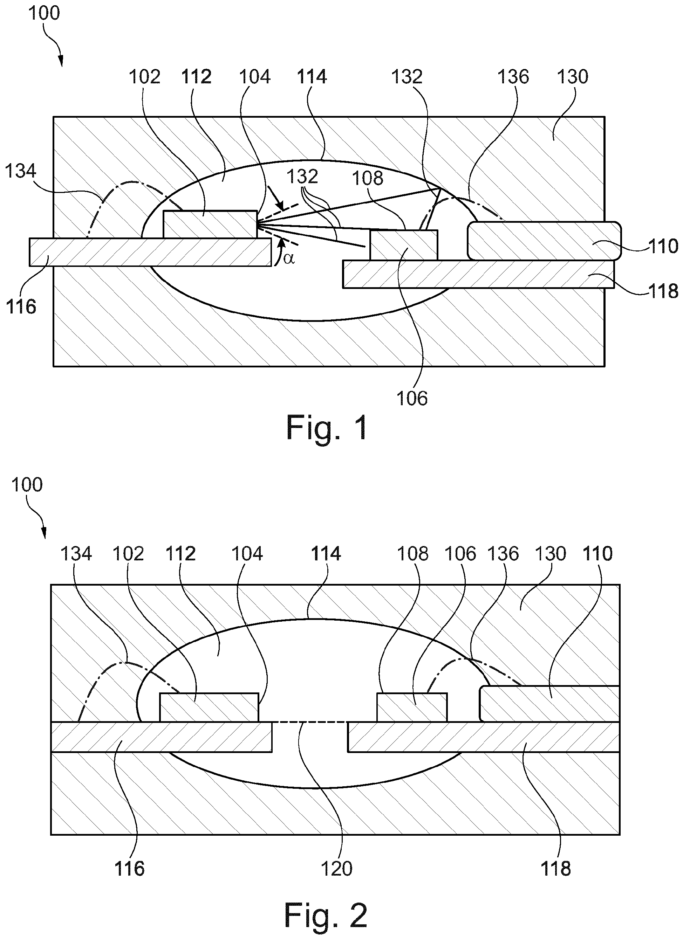

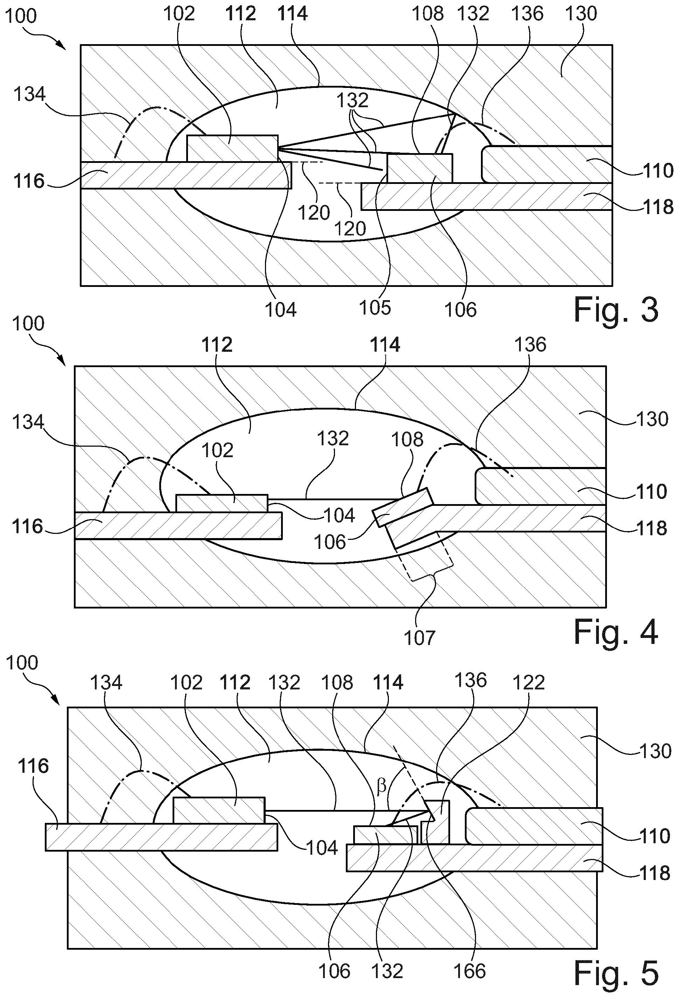

There is still potentially room to improve an optical coupling of an optocoupler.
US 5 753 929 A discloses a multi-directional optocoupler which comprises light emitting devices, e.g. VCSELs, and light detecting devices, e.g. photodetectors. The light emitting devices are capable of generating a light signal which travels through regions 24, 25 towards the light detecting devices. Figure 1 discloses a horizontal arrangement, wherein the light emitting devices and the light detecting devices are arranged side by side. Figure 4 discloses a vertical (or stacked) arrangement, wherein the light emitting devices and the light detecting devices are arranged superimposed to each other.
US 5 574 744 A discloses an optocoupler comprising multiple optocoupling stacks. Each optocoupling stack comprises a VCSEL which is directing light to photodetectors arranged below the VCSELs. The optocoupler may comprise an array-like arrangement of a plurality of adjacent optical stacks.

US 2007/0241343 Al discloses a photo coupler comprising a semiconductor laser and a semiconductor light-receiver which are arranged on electrodes which act as carriers and are connected with the electrodes, by wires. A waveguide which comprises a light reflective portion is arranged between the semiconductor laser and the semiconductor light-receiver.

US 2011/0235974 Al discloses an optocoupler which comprises an optical transmitter die which transmits a ray of light onto a surface of an optical receiver die. A first encapsulant and a second encapsulant enclose the optical transmitter die and the optical receiver die. To enable a ray of light which is emitted from a side of the optical transmitter die being received at an upper surface of the optical receiver die, the optical transmitter die is arranged on an elevated portion of a conductive pad.

### Summary of the invention

There may be a need for an optocoupler with improved optical coupling.

According to an exemplary embodiment, an optocoupler is provided which comprises a side-emitting electromagnetic radiation source for emitting electromagnetic radiation at its side wall, and a plate-shaped electromagnetic radiation detector for detecting at least part of the emitted electromagnetic radiation; the opto-coupler further comprises a source carrier on which the electromagnetic radiation source is mounted, and a detector carrier on which the electromagnetic radiation detector is mounted, wherein the electromagnetic radiation detector is configured for detecting electromagnetic radiation at its upper main surface and wherein at least a part of at least one of the source carrier and the detector carrier is slanted so that the electromagnetic radiation source and the electromagnetic radiation detector are tilted with respect to each other.

According to another exemplary embodiment, a method of operating an optocoupler is provided, wherein the method comprises emitting electromagnetic radiation at a side wall of a side-emitting electromagnetic radiation source, and detecting at least part of the emitted electromagnetic radiation by an electromagnetic radiation detector.

According to an exemplary embodiment, an optocoupler is provided which has an electromagnetic radiation source irradiating electromagnetic radiation (such as light) predominantly or completely via its side face. Thus, the side-emitting electromagnetic radiation source may emit electromagnetic radiation to propagate substantially horizontally, rather than via a top or bottom main surface. As a result, an improved optical coupling between such a side-emitting electromagnetic radiation source and an electromagnetic radiation detector arranged side by side with the electromagnetic radiation source may be obtained, since this geometry and configuration enables a direct transmission of electromagnetic radiation along a short propagation path. Contrary to conventional approaches, an electromagnetic radiation beam may thus propagate predominantly horizontally through the optocoupler on its way from the electromagnetic radiation source to the electromagnetic radiation detector. An improved optical coupling between electromagnetic radiation source and electromagnetic radiation detector may therefore result in a more reliable and more failure robust operation of the optocoupler. The latter may for example be embodied as a switching solid-state relay.

### Description of further exemplary embodiments

In the following, further exemplary embodiments of the optocoupler and the method will be explained.

In the context of the present application, the term "optocoupler" may particularly denote an optoelectronic component which couples two electrically conductive but electrically separated electric circuits with each other by an optical link provided by an electromagnetic radiation beam, such as a light beam. Such an optical coupling may be provided between an electromagnetic radiation source being galvanically separated from or electrically decoupled from an electromagnetic radiation detector.

In the context of the present application, the term "electromagnetic radiation source" may particularly denote a component which is capable of generating and emitting an electromagnetic radiation beam, in particular in a directed way. According to an exemplary embodiment, the electromagnetic radiation source may be configured for emitting an electromagnetic radiation beam propagating along an approximately horizontal rather than vertical direction. For instance, the emitted electromagnetic radiation beam may be a light beam, more particularly a beam of visible light. The electromagnetic radiation source may convert an electric signal to be transmitted to the electromagnetic radiation detector side into an optical signal for transmission via the optic link.

In the context of the present application, the term "electromagnetic radiation detector" may particularly denote an electronic component capable of detecting electromagnetic radiation (such as light) received from the electromagnetic radiation source and converting the signal to which the transmitted electromagnetic radiation relates into an electric signal for further processing on the detector side. For instance, the electromagnetic radiation detector may be configured for detecting electromagnetic radiation in a limited bandwidth, i.e. in a limited range of wavelengths. The emission characteristics of the electromagnetic radiation source and the detection characteristic of the electromagnetic radiation detector may be adjusted to match.

In the context of the present application, the term "side-emitting" electromagnetic radiation source may particularly denote that the surface of the electromagnetic radiation source at which the electromagnetic radiation (such as visible light) is emitted is a (in particular vertically oriented) side wall rather than a (for instance horizontally oriented) main surface. For instance, such an electromagnetic radiation source may be a plate-shaped element or a cuboid element which emits the light along a relatively small side wall rather than along a larger top surface or bottom surface. When the side-emitting electromagnetic radiation source is a laser diode, electromagnetic radiation in an interior of the laser diode may propagate in the laser resonator between an ideal mirror and an intentionally non-ideal mirror. Both the ideal mirror and the non-ideal mirror may be formed by a respective side wall of the laser diode. For example, the non-ideal mirror side wall may have a larger roughness and therefore intentionally reduced reflection capability as compared to the ideal mirror. The electromagnetic radiation propagating between said two side walls may then be emitted predominantly or even exclusively via the non-ideal mirror side wall.

In an embodiment, the electromagnetic radiation source is a laser diode. For example, such a laser diode may be manufactured in semiconductor technology, in particular in silicon technology or gallium arsenide technology. A laser diode may be powered by an electric current and may generate at a pn-junction electromagnetic radiation which can be emitted via a side surface of the laser diode. By taking this measure, a specifically directed electromagnetic radiation beam may be emitted for propagation towards the electromagnetic radiation detector for detection.

As an alternative to a laser diode, the side-emitting electromagnetic radiation source may be embodied in accordance with DLP (Digital Light Processing) technology (for instance implementing micromirrors).

In an embodiment, the electromagnetic radiation detector is a photodiode. A photodiode may be an optical element having a pn-junction and being capable of capturing electromagnetic radiation for transferring it into electric charges, and thus into an electric voltage or an electric current. For example, a light sensitive surface of a (in particular plate-shaped or cuboid) photodiode may be an upper or lower main surface thereof. Thus, a large detection surface is provided by a photodiode.

In an embodiment, the electromagnetic radiation source and the electromagnetic radiation detector are galvanically separated. In the context of the present application, the term "galvanically separated" may particularly denote that the electromagnetic radiation source and the electromagnetic radiation detector are electrically decoupled from each other so that no electric signal can propagate directly from the electromagnetic radiation source to the electromagnetic radiation detector. Thus, the communication between the two galvanically separated portions of the optocoupler is provided by the optical link between electromagnetic radiation source and electromagnetic radiation detector. This optical path may bridge electrical paths, which are separate from each other, at the side of the electromagnetic radiation source and at the side of the electromagnetic radiation detector.

In an embodiment, the electromagnetic radiation source is configured for emitting electromagnetic radiation only at its side wall and not or not substantially at any one of its main surfaces. By triggering the emission of electromagnetic radiation to occur via a side wall of the electromagnetic radiation source only, a well-defined and directed transmission of the electromagnetic radiation may be enabled. This renders the transmission efficiency of the optocoupler high.

In an embodiment, the electromagnetic radiation detector is configured for detecting electromagnetic radiation at one of its main surfaces, in particular only at one of its main surfaces. This may be done by forming the pn-junction of a photodiode type electromagnetic radiation detector close to an upper main surface thereof. By using a large main surface of the electromagnetic radiation detector for detection purposes, a high detection efficiency may be achieved.

In an embodiment, the optocoupler comprises a control unit coupled with the electromagnetic radiation detector and configured for carrying out a control task (in particular carrying out a switching task) or for controlling (in particular switching) based on the detected electromagnetic radiation. For instance, such a control unit may be one or multiple semiconductor chips and/or any other circuitry. It is also possible that the control unit comprises software elements. The control unit may be provided with the signals detected by the electromagnetic radiation detector. The control unit may then further process such signals so as to recover an electric signal which was transmitted in the form of the electromagnetic radiation from the electromagnetic radiation source.

In an embodiment, the optocoupler comprises an optically transparent encapsulant, in particular a transparent gel, in which at least part of the electromagnetic radiation source and at least part of the electromagnetic radiation detector are embedded. Such an optically transparent encapsulant may be optically transparent in a wavelength range of the electromagnetic radiation propagating between the electromagnetic radiation source and the electromagnetic radiation detector. In this context, electrically transparent may denote a property of the encapsulant according to which the encapsulant is substantially non-absorbent for the electromagnetic radiation transmitted between electromagnetic radiation source and electromagnetic radiation detector. For instance, the encapsulant may be a transparent gel through which visible light may propagate with low loss or low damping.

In an embodiment, the optocoupler comprises a housing body surrounding at least part of the electromagnetic radiation source and at least part of the electromagnetic radiation detector and having a reflective interior surface configured for reflecting at least part of (in particular for totally reflecting) electromagnetic radiation emitted by the electromagnetic radiation source. For instance, at an interior bounding surface of the housing body (which may correspond to an outer bounding surface of the encapsulant), electromagnetic radiation propagating from the electromagnetic radiation source and away from the electromagnetic radiation detector may be reflected and may thus be promoted to propagate towards the electromagnetic radiation detector. Thus, the efficiency of the optical transmission may be further improved. For instance, at least part of the housing body may be opaque to thereby disable or at least suppress undesired propagation of environmental light to the electromagnetic radiation detector.

In an embodiment, said interior reflective surface of the housing body (which may correspond to an exterior surface of the optically transparent encapsulant) is configured for reflecting and directing at least part of the electromagnetic radiation onto the electromagnetic radiation detector. In particular, a curved (for instance elliptically curved) reflective surface may be configured in a way so that it focuses electromagnetic radiation onto the light sensitive surface of the electromagnetic radiation detector. This may further improve the efficiency of the optical coupling.

In an embodiment, the electromagnetic radiation source is configured for emitting red light, in particular exclusively red light. When using an electromagnetic radiation source emitting in the range of red light (i.e. around 600 nm), relatively simple components may be used for electromagnetic radiation source and electromagnetic radiation detector and undesired losses due to scattering can be kept small.

In an embodiment, the optocoupler comprises a source carrier on which the electromagnetic radiation source is mounted. Furthermore, the optocoupler may comprise a detector carrier on which the electromagnetic radiation detector is mounted. Said carriers may be electrically conductive. For instance, said carriers may be leadframes, for instance made of copper. Alternatively, other kind of carriers may be used, for example a carrier with an electrically insulating and thermally conductive layer (for instance ceramic), covered on both opposing main surfaces thereof with a respective copper foil. For instance, a Direct Copper Bonding (DCB) substrate or a Direct Aluminium Bonding (DAB) substrate may be used. The source carrier and the detector carrier may be galvanically separated or electrically decoupled from each other. By taking this measure, a direct electric connection between electromagnetic radiation source and electromagnetic radiation detector and the assigned circuit portions may be prevented, and the bridge in between may be provided by the optical link.

In one embodiment, source carrier and detector carrier may be separate carriers. In another embodiment, source carrier and detector carrier may be different sections of a common carrier. For instance, the source carrier and the detector carrier are leadframes or are separated sections of a common leadframe. When embodied as one or two leadframes, the carriers may be provided with small effort and may simultaneously fulfil a mechanical supporting function and an electric function. In such a scenario, at least one of the carriers may transport an electric signal which is converted into an optical signal at the optical interface between electromagnetic radiation source and electromagnetic radiation detector.

In an embodiment, the source carrier and the detector carrier are plate shaped planar structures. This allows the manufacture of the optocoupler in a vertically compact way.

In an embodiment, the source carrier and the detector carrier are arranged at the same vertical level. When arranged at the same level, the electromagnetic propagation path may be rendered very short.

In an embodiment, the source carrier is arranged at a higher vertical level than the detector carrier so that the light-emitting side wall is arranged at a higher vertical level than a side wall of the electromagnetic radiation detector. When emitting the electromagnetic beam via a side wall of the electromagnetic radiation source and detecting the electromagnetic beam at a top-side main surface of the electromagnetic radiation detector, it may be preferred, for an efficient optical link, to arrange the electromagnetic radiation detector at a lower vertical level than the electromagnetic radiation source. This may render the optical transmission even more efficient.

At least part of at least one of the source carrier and the detector carrier is slanted so that the electromagnetic radiation source and the electromagnetic radiation detector are tilted with respect to each other. Preferably, a portion of the detector carrier may be slanted with respect to a remaining planar portion of the detector carrier as well as with respect to the source carrier. In such a configuration, the electromagnetic radiation propagating from the side wall of the electromagnetic radiation source hits the light sensitive surface of the electromagnetic radiation detector being slanted with respect to a horizontal direction with high efficiency. This renders the transmission of the optical signal even more efficient. Tilting a portion of the detector carrier may for instance be accomplished by bending a corresponding portion of a leadframe.

In an embodiment, the optocoupler comprises a deflector arranged for deflecting at least part of the emitted electromagnetic radiation onto the electromagnetic radiation detector. Such a deflector may deflect electromagnetic radiation which has propagated from the electromagnetic radiation source to the electromagnetic radiation detector without reaching the light sensitive surface of the electromagnetic radiation detector. By deflecting such light back onto the light sensitive surface of the electromagnetic radiation detector further improves the efficiency of the light transmission.

In an embodiment, the deflector is mounted on a detector carrier on which also the electromagnetic radiation detector is mounted. Thus, no additional mounting base for the deflector is necessary which renders the optocoupler compact and light in weight.

In an embodiment, the electromagnetic radiation detector is arranged between the electromagnetic radiation source and the deflector. For instance, electromagnetic radiation source, electromagnetic radiation detector and deflector may be arranged along a substantially longitudinal path so that electromagnetic radiation which has missed the detection surface of the electromagnetic radiation detector can be deflected by the deflector back onto the detecting surface.

In an embodiment, the deflector has a deflecting surface being angled with a deflection angle in a range between 30° and 60°, in particular about 45°, with respect to incident electromagnetic radiation emitted by the electromagnetic radiation source and being deflected onto the electromagnetic radiation detector. It has turned out that, with the mentioned deflection angles, an efficient deflection of electromagnetic radiation onto the detection surface of the electromagnetic radiation detector is possible.

In an embodiment, the deflector comprises or consists of a solderable material (for instance a metallic material such as copper). In particular, the deflector may be soldered onto a detector carrier (for instance a leadframe portion made of copper) on which the electromagnetic radiation detector is mounted. Thus, the deflector can be soldered onto the detector carrier, for instance a leadframe.

In an embodiment, the optocoupler is configured as relay, in particular solid-state relay. The optocoupler may thus be integrated in a solid-state switch which allows to carry out a switching performance in an electric circuit. The switching can be carried out based on the optical signal transmitted from the electromagnetic radiation source to the electromagnetic radiation detector without galvanic coupling in between.

In an embodiment, the electromagnetic radiation source is configured for emitting at least 60%, in particular at least 80%, of an overall intensity of the electromagnetic radiation at its side wall within an angular range of not more than 45°, in particular of not more than 30°, around an axis perpendicular to the side wall. With such a configuration, it may be possible to concentrate the major part of the emitted electromagnetic radiation intensity within a narrow cone having an axis perpendicular to the (for instance vertical planar) side wall. Thus, a highly efficient transfer of electromagnetic radiation from the side-emitting electromagnetic radiation source to the electromagnetic radiation detector may be enabled.

In an embodiment, the side-emitting electromagnetic radiation source is configured for emitting substantially monochromatic electromagnetic radiation. Correspondingly, the electromagnetic radiation detector may be configured for detecting substantially only said substantially monochromatic electromagnetic radiation, i.e. being specifically sensitive to said wavelength. As a substantially monochromatic light source configured for side-emission, an appropriate laser diode may be implemented. In particular, when the side-emitting electromagnetic radiation source is configured as a laser diode, it will emit a very narrow bandwidth which is substantially monochromatic. Highly advantageously, the electromagnetic radiation detector may be matched concerning its detection sensitivity to said substantially monochromatic electromagnetic radiation emitted by the side-emitting electromagnetic radiation source. For instance, it is possible to adjust the band gap of the semiconductor material of the electromagnetic radiation detector (for instance a photodiode) so that the band gap fits to the emitted monochromatic electromagnetic radiation. By taking this measure, the signal-to-noise ratio may be reduced, the detection efficiency may be increased, and the suppression of unspecific environmental light and underground signals may be promoted. As a result, a highly efficient optocoupler is obtained.

The electromagnetic radiation detector is configured for detecting the electromagnetic radiation exclusively at an upper main surface of the electromagnetic radiation detector. In particular, the electromagnetic radiation detector may be configured as a photodiode having its pn-junction at the upper main surface. Thus, the detection efficiency is by far the largest in this upper main surface of the electromagnetic radiation detector. Hence, the mutual orientation between side-emitting electromagnetic radiation source and electromagnetic radiation detector may be adjusted so as to achieve a proper efficiency of transmitting the light and thereby the information.

As substrate or wafer forming the basis of implemented electronic chips, a semiconductor substrate, preferably a silicon substrate, may be used. Alternatively, a silicon oxide or another insulator substrate may be provided. It is also possible to implement a germanium substrate or a III-V-semiconductor material. For instance, exemplary embodiments may be implemented in GaN or SiC technology.

Furthermore, exemplary embodiments may make use of standard semiconductor processing technologies such as appropriate etching technologies (including isotropic and anisotropic etching technologies, particularly plasma etching, dry etching, wet etching), patterning technologies (which may involve lithographic masks), deposition technologies (such as chemical vapor deposition (CVD), plasma enhanced chemical vapor deposition (PECVD), atomic layer deposition (ALD), sputtering, etc.).

The above and other objects, features and advantages of the present invention will become apparent from the following description and the appended claims, taken in conjunction with the accompanying drawings, in which like parts or elements are denoted by like reference numbers.

### Brief description of the drawings

The accompanying drawings, which are included to provide a further understanding of exemplary embodiments and constitute a part of the specification, illustrate exemplary embodiments.

In the drawings:
**Figure 1** shows a cross-sectional view of an optocoupler according to an exemplary embodiment, not comprised in the scope of the appended claims.
**Figure 2** shows a cross-sectional view of an optocoupler according to another exemplary embodiment, not comprised in the scope of the appended claims.
**Figure 3** shows a cross-sectional view of an optocoupler according to still another exemplary embodiment, not comprised in the scope of the appended claims.
**Figure 4** shows a cross-sectional view of an optocoupler according to yet another exemplary embodiment.
**Figure 5** shows a cross-sectional view of an optocoupler according to still another exemplary embodiment, not comprised in the scope of the appended claims.

### Detailed description of exemplary embodiments

The illustration in the drawing is schematically.

Before describing further exemplary embodiments in further detail, some basic considerations of the present inventors will be summarized based on which exemplary embodiments have been developed.

According to an exemplary embodiment, an optocoupler (preferably embodied as solid-state relay) may be provided which may use a side-emitting arrangement. Thus, a side-emitting electromagnetic radiation source (for instance a laser diode) may be implemented instead of a light-emitting diode (LED) based front-to-front arrangement. By taking this measure, exemplary embodiments may provide an improved directional optical transmission.

Solid-state relays may use one more optocouplers for providing a galvanic separation of electrical potentials. On one side, an emitting device may be provided for emitting light, on the other side a photodetector may be provided for detecting that light and reacting with an electrical change in parameters (for example resistance) or generating (for instance in the presence of a solar cell) to trigger a secondary power device which switches the actual solid-state relay.

In all cases, a good optical coupling between the light generation and the light detection may be advantageous, as the amount of light detected at the detector may be correlated to the switching speed.

An exemplary embodiment provides an architecture capable of improving this optical coupling. Instead of a front-side-emitting LED, such an exemplary embodiment may use a side-emitting device, for instance a laser diode.

Exemplary embodiments may provide an optocoupler having a highly efficient low loss coupling between the input side (i.e. the side-emitting electromagnetic radiation source) and the output side (i.e. the electromagnetic radiation detector). Descriptively speaking, the emission characteristic of the side-emitting electromagnetic radiation source may be precisely defined, i.e. at its vertical side wall, so that a defined irradiation direction is obtained. Hence, it is possible to arrange the electromagnetic radiation detector with its light sensitive surface in accordance with the emission direction of the side-emitting electromagnetic radiation source, to thereby obtain a highly efficient optical coupling between the source side and the detector side. In other words, the radiation path may be adjusted directly from a left-hand side to a right-hand side of the optocoupler. To further increase the transmission efficiency, it is possible to slightly tilt the electromagnetic radiation detector with respect to the emitting side wall of the electromagnetic radiation source. Said tilting may be for instance in an angular range between 10° and 50°, in particular in a range between 20° and 40°, preferably around 30°.

**Figure 1** shows a cross-sectional view of an optocoupler 100 according to an exemplary embodiment, not comprised in the scope of the appended claims. The optocoupler 100 functions as a solid-state relay.

The illustrated optocoupler 100 comprises a side-emitting electromagnetic radiation source 102 for emitting electromagnetic radiation 132 at its side wall 104. The electromagnetic radiation source 102 may be a laser diode configured for emitting substantially monochromatic or at least narrow bandwidth light, preferably red light. Further preferably, the electromagnetic radiation source 102 may be configured for emitting electromagnetic radiation 132 only at its side wall 104 (i.e. at its vertical surface on the right-hand side according to Figure 1), and not at any one of its main surfaces (i.e. the two opposing horizontal surfaces of the electromagnetic radiation source 102 according to Figure 1) or its other side walls.

An electromagnetic radiation detector 106 may be provided in the optocoupler 100 for detecting emitted electromagnetic radiation 132 which has propagated up to a light-sensitive surface of the electromagnetic radiation detector 106. The electromagnetic radiation detector 106 may be a photodiode with a light-sensitive upper main surface. Thus, said electromagnetic radiation detector 106 is configured for detecting the electromagnetic radiation 132 for example only at its upper main surfaces 108 according to Figure 1.

As shown, the side-emitting electromagnetic radiation source 102 and the electromagnetic radiation detector 106 are arranged side-by-side (rather than vertically stacked) so that the electromagnetic radiation 132 emitted by the electromagnetic radiation source 102 propagates substantially horizontally up to the electromagnetic radiation detector 106.

The electromagnetic radiation source 102 and the electromagnetic radiation detector 106 are galvanically separated, i.e. electrically insulated with respect to each other and are coupled by the optical link provided by the propagating electromagnetic radiation 132.

As shown in Figure 1 as well, the optocoupler 100 comprises a planar plate shaped metallic source carrier 116 on which the electromagnetic radiation source 102 is mounted, for instance by soldering or sintering. Moreover, a planar plate shaped metallic detector carrier 118 is provided on which the electromagnetic radiation detector 106 is mounted, for instance by soldering or sintering. By an electrically conductive connection element 134, such as a bond wire or bond ribbon or alternatively a clip, an upper main surface of the electromagnetic radiation source 102 is electrically connected to the source carrier 116. Correspondingly, an upper main surface of the electromagnetic radiation detector 106 is electrically connected to a control unit 110 (described below in further detail) by an electrically conductive connection element 136, such as a bond wire or bond ribbon or alternatively a clip. For example, the source carrier 116 and the detector carrier 118 may be two separate metallic carriers (for instance two leadframes) or may be separated sections of a common metallic carrier (such as a common leadframe). Such a leadframe may for instance be made of copper and may be a patterned or stamped metal plate. Source carrier 116 and detector carrier 118 may be electrically decoupled.

As already mentioned, the optocoupler 100 also comprises control unit 110 coupled with the electromagnetic radiation detector 106 and configured for carrying out a control task (in particular switch task) based on the signal content of the detected electromagnetic radiation 132. The control unit 110 may be a semiconductor chip or an arrangement of semiconductor chips and may be electrically coupled with the electromagnetic radiation detector 106 for further processing the detected signals after converting the detected electromagnetic radiation 132 into an electric signal.

As shown as well in Figure 1, the optocoupler 100 comprises an optically transparent encapsulant 112, such as a transparent gel, in which the electromagnetic radiation source 102 and the electromagnetic radiation detector 106 are embedded in such a way that the electromagnetic radiation propagates within the optically transparent encapsulant 112 with low losses.

An opaque housing body 130 surrounding part of the electromagnetic radiation source 102 and part of the electromagnetic radiation detector 106 has a reflective interior surface 114 configured for reflecting (preferably for totally reflecting) electromagnetic radiation 132 emitted by the electromagnetic radiation source 102. An exterior surface of the optically transparent encapsulant 112, which corresponds to the reflective interior surface 114 of the housing body 130, is configured for reflecting the electromagnetic radiation 132, partially or entirely. More specifically, the reflective interior surface 114 may be configured for reflecting and directing the electromagnetic radiation 132 onto the electromagnetic radiation detector 106. Housing body 130 may be a casing or a further encapsulant.

The electromagnetic radiation source 102 embodied as laser diode may emit narrow bandwidth light, which can be chosen in accordance with the absorption properties of the transparent gel constituting encapsulant 112, for instance in order to fit into the best possible transmission window. Preferably, red light may be used, since this may allow implementing components of the optocoupler 100 with reasonable effort.

The embodiment of Figure 1 shows how electromagnetic radiation 132, such as visible light in the red wavelength range, is emitted by the electromagnetic radiation source 102. In the emitted electromagnetic radiation 132, an information is included which is to be transmitted to the electromagnetic radiation detector 106. The corresponding electromagnetic radiation 132 is emitted exclusively via a vertical side wall 104 of the plate-shaped electromagnetic radiation source 102. As shown in Figure 1, the propagation path up to the light-sensitive surface 108 on an upper side of the plate-shaped electromagnetic radiation detector 106 is short and thus the emission efficiency high. Furthermore, the reflection at the curved surface 114 between the optically transparent encapsulant 112 and the housing body 130 further increases the amount of electromagnetic radiation 132 propagating up to the light-sensitive upper main surface 108 of the electromagnetic radiation detector 106. The electric connection between the source carrier 116 and the electromagnetic radiation source 102 is accomplished by the electrically conductive connection element 134. Thus, an electric signal may be conducted along the source carrier 116 via the electrically conductive connection element 134 up to the electromagnetic radiation source 102 where the electric signal is converted into the electromagnetic radiation 132. The latter is then transmitted to the electromagnetic radiation detector 106 for detection. The detected electromagnetic radiation 132 is then converted into an electric signal in the electromagnetic radiation detector 106. The latter electric signal is then forwarded via further electrically conductive connection element 136 to control unit 110. It is alternatively also possible that the detector carrier 118 also carries the electric signal.

As shown in Figure 1 as well, the electromagnetic radiation source 102 may be configured for emitting a major portion of for instance at least 60% of an intensity of the electromagnetic radiation 132 via its side wall 104 within a narrow angular range α of for instance 30° around an axis extending horizontally according to Figure 1 and perpendicular to the side wall 104. With such a configuration of focusing the major part of the emitted electromagnetic radiation intensity within a narrow cone having an axis perpendicular to the emitting side wall 104, a highly efficient transfer of electromagnetic radiation 132 from the side-emitting electromagnetic radiation source 102 to the electromagnetic radiation detector 106 may be promoted.

**Figure 2** shows a cross-sectional view of an optocoupler 100 according to another exemplary embodiment, not comprised in the scope of the appended claims.

The embodiment of Figure 2 differs from the embodiment shown in Figure 1 in that, according to Figure 2, the source carrier 116 and the detector carrier 118 are arranged at the same vertical level 120. Since both source carrier 116 and detector carrier 118 are at the same vertical level, they can be realized by a common patterned or structured metal plate.

According to Figure 2, one leadframe constituents the source carrier 116 and the detector carrier 118 which are therefore located at the same vertical level, although being electrically decoupled from each other. Hence, a very simple embodiment is shown in Figure 2 where both emitter (i.e. electromagnetic radiation source 102) and detector (i.e. electromagnetic radiation detector 106) are located at the same vertical level. This embodiment relies on diffusion of the side emission in the transparent gel which forms optically transparent encapsulant 112 in order to illuminate the front-side, i.e. light-sensitive surface 108, of the electromagnetic radiation detector 106.

**Figure 3** shows a cross-sectional view of an optocoupler 100 according to still another exemplary embodiment, not comprised in the scope of the appended claims.

The embodiment of Figure 3 differs from the embodiment shown in Figure 2 in that, according to Figure 3, the source carrier 116 is arranged at a higher vertical level 120 than the detector carrier 118. As a result, the light-emitting side wall 104 is arranged at a higher vertical level than a facing side wall 105 of the electromagnetic radiation detector 106.

Thus, Figure 3 shows source carrier 116 and detector carrier 118 embodied as two parallel leadframes at different height levels. If the side emitter is slightly elevated as shown in Figure 3, an even better geometric coupling and illumination capture can be obtained.

**Figure 4** shows a cross-sectional view of an optocoupler 100 according to yet another exemplary embodiment.

According to Figure 4, a part of the detector carrier 118 is slanted (for instance by bending a metal plate) so that the electromagnetic radiation source 102 and the electromagnetic radiation detector 106 are tilted with respect to each other.

Descriptively speaking, the source-facing end section 107 of detector carrier 118 is bent for providing a face-to-face leadframe architecture for improving optical transmission efficiency. Thus, the advantages achievable by the described side emission can be combined with the illustrated advantageous tilting of at least one of the involved elements (i.e. electromagnetic radiation source 102, electromagnetic radiation detector 106, source carrier 116 and detector carrier 118).

The optical efficiency in the transmission geometry according to Figure 4 is highly advantageous, since the detector carrying portion of the detector carrier 118 is slanted. Consequently, the electromagnetic radiation detector 106 can be attached or mounted on the detector carrier 118 so that the slanted upper detecting surface 108 of the electromagnetic radiation detector 106 is properly oriented with respect to emitting side wall 106 of the electromagnetic radiation source 102. Thus, as shown, the emitted electromagnetic radiation 132 may propagate substantially horizontally from side wall 104 to surface 108.

**Figure 5** shows a cross-sectional view of an optocoupler 100 according to still another exemplary embodiment, not comprised in the scope of the appended claims.

The optocoupler 100 according to Figure 5 comprises a deflector 122 arranged for deflecting part of the emitted electromagnetic radiation 132 onto the electromagnetic radiation detector 106, to thereby increase the portion of the emitted electromagnetic radiation 132 which can be detected on the light-sensitive surface 108 of the electromagnetic radiation detector 106. As shown, the deflector 122 is mounted in a simple way on detector carrier 118 on which also the electromagnetic radiation detector 106 is mounted. The electromagnetic radiation detector 106 is thus arranged in a horizontal direction between the electromagnetic radiation source 102 and the deflector 122. The illustrated deflector 122 has a deflecting surface 166 being angled with a deflection angle β=45° with respect to said part of the incident electromagnetic radiation 132 to be deflected onto the electromagnetic radiation detector 106. Preferably, the deflector 122 may be made of a solderable material and may be soldered onto detector carrier 118 on which the electromagnetic radiation detector 106 is mounted.

Hence, Figure 5 shows a reflector or deflector 122 on the receiving leadframe side. This configuration with laser diode may result in a highly directional illumination. 45°-angled deflector 122 can be used particularly advantageous to further increase illumination capture. Deflector material is preferably made from a solderable material and may be attached similar to a clip.

By the arrangement of the deflector 122 vertically protruding beyond the electromagnetic radiation detector 106, horizontally propagating light originating from the side wall 104 of the electromagnetic radiation source 102 and propagating horizontally may be deflected efficiently onto the light sensitive upper main surface 108 of the electromagnetic radiation detector 106, to thereby further improve the optical coupling efficiency.

It should be noted that the term "comprising" does not exclude other elements or features and the "a" or "an" does not exclude a plurality. Also, elements described in association with different embodiments may be combined. It should also be noted that reference signs shall not be construed as limiting the scope of the claims. Moreover, the scope of the present application is not intended to be limited to the particular embodiments of the process, machine, manufacture, composition of matter, means, methods and steps described in the specification. Accordingly, the appended claims are intended to include within their scope such processes, machines, manufacture, compositions of matter, means, methods, or steps.

## Claims

1. An optocoupler (100), which comprises:
• a side-emitting electromagnetic radiation source (102) for emitting electromagnetic radiation at its side wall (104); and
• a plate-shaped electromagnetic radiation detector (106) for detecting at least part of the emitted electromagnetic radiation;
• a source carrier (116) on which the electromagnetic radiation source (102) is mounted, and a detector carrier (118) on which the electromagnetic radiation detector (106) is mounted;
• wherein the electromagnetic radiation detector (106) is configured for detecting electromagnetic radiation at its upper main surface (108);
• **characterised in that** at least a part of at least one of the source carrier (116) and the detector carrier (118) is slanted so that the electromagnetic radiation source (102) and the electromagnetic radiation detector (106) are tilted with respect to each other.

2. The optocoupler (100) according to claim 1, wherein the electromagnetic radiation source (102) is a laser diode.

3. The optocoupler (100) according to claim 1 or 2, wherein the electromagnetic radiation detector (106) is a photodiode.

4. The optocoupler (100) according to any of claims 1 to 3, wherein the electromagnetic radiation source (102) and the electromagnetic radiation detector (106) are electrically decoupled from each other.

5. The optocoupler (100) according to any of claims 1 to 4, wherein the electromagnetic radiation source (102) is configured for emitting electromagnetic radiation substantially only at its side wall (104).

6. The optocoupler (100) according to any of claims 1 to 5, comprising a control unit (110) coupled with the electromagnetic radiation detector (106) and configured for carrying out a control task, in particular a switching task, based on the detected electromagnetic radiation.

7. The optocoupler (100) according to any of claims 1 to 6, comprising an optically transparent encapsulant (112), in particular a transparent gel, in which at least part of the electromagnetic radiation source (102) and at least part of the electromagnetic radiation detector (106) are embedded.

8. The optocoupler (100) according to any of claims 1 to 7, comprising a housing body (130) surrounding at least part of the electromagnetic radiation source (102) and at least part of the electromagnetic radiation detector (106) and having a reflective interior surface (114) configured for reflecting at least part of, in particular for totally reflecting, electromagnetic radiation emitted by the electromagnetic radiation source (102), wherein the reflective interior surface (114) is in particular configured for reflecting and directing at least part of the electromagnetic radiation onto the electromagnetic radiation detector (106).

9. The optocoupler (100) according to any of claims 1 to 8, comprising at least one of the following features:
• wherein the electromagnetic radiation source (102) is configured for emitting red light, in particular exclusively red light;
• the optocoupler (100) is configured as relay, in particular solid-state relay;
• wherein the electromagnetic radiation source (102) is configured for emitting at least 60%, in particular at least 80%, of an intensity of the emitted electromagnetic radiation at its side wall (104) within an angular range (α) of not more than 45°, in particular of not more than 30°, around an axis perpendicular to the side wall (104);
• wherein the side-emitting electromagnetic radiation source (102) is configured for emitting substantially monochromatic electromagnetic radiation, and the electromagnetic radiation detector (106) is configured for detecting substantially only within a narrow wavelength band around a wavelength of said emitted substantially monochromatic electromagnetic radiation;
• wherein the side-emitting electromagnetic radiation source (102) and the electromagnetic radiation detector (106) are arranged side-by-side.

10. The optocoupler (100) according to any of claims 1 to 9, comprising at least one of the following features:
• wherein the source carrier (116) and the detector carrier (118) are leadframes or are separated sections of a common leadframe;
• wherein the source carrier (116) and the detector carrier (118) are arranged at the same vertical level (120);
• wherein the source carrier (116) is arranged at a higher vertical level (120) than the detector carrier (118) so that the light-emitting side wall (104) is arranged at a higher vertical level (120) than a side wall of the electromagnetic radiation detector (106).

11. The optocoupler (100) according to any of claims 1 to 10, comprising a deflector (122) arranged for deflecting at least part of the emitted electromagnetic radiation onto the electromagnetic radiation detector (106).

12. The optocoupler (100) according to claim 11, comprising at least one of the following features:
• the deflector (122) is mounted on a detector carrier (118) on which the electromagnetic radiation detector (106) is mounted;
• the electromagnetic radiation detector (106) is arranged between the electromagnetic radiation source (102) and the deflector (122);
• the deflector (122) has a deflecting surface (166) being angled with a deflection angle (β), in particular in a range between 30° and 60°, with respect to incident electromagnetic radiation to be deflected onto the electromagnetic radiation detector (106);
• wherein the deflector (122) comprises or consists of a solderable material, in particular is soldered onto a detector carrier (118), more particularly a leadframe, on which the electromagnetic radiation detector (106) is mounted.

13. A method of operating an optocoupler (100), wherein the method comprises:
• emitting electromagnetic radiation at a side wall (104) of a side-emitting electromagnetic radiation source (102); and
• detecting at least part of the emitted electromagnetic radiation by a plate-shaped electromagnetic radiation detector (106);
• wherein the optocoupler (100) comprises a source carrier (116) on which the electromagnetic radiation source (102) is mounted, and comprises a detector carrier (118) on which the electromagnetic radiation detector (106) is mounted;
• wherein the electromagnetic radiation detector (106) is configured for detecting electromagnetic radiation at its upper main surface (108);
• **characterised in that** at least a part of at least one of the source carrier (116) and the detector carrier (118) is slanted so that the electromagnetic radiation source (102) and the electromagnetic radiation detector (106) are tilted with respect to each other.

## Patentansprüche

1. Ein Optokoppler (100), der aufweist:
• eine seitenemittierende elektromagnetische Strahlungsquelle (102) zum Emittieren elektromagnetischer Strahlung an ihrer Seitenwand (104); und
• einen plattenförmigen elektromagnetischen Strahlungsdetektor (106) zum Detektieren zumindest eines Teils der emittierten elektromagnetischen Strahlung;
• einen Quellenträger (116), auf dem die elektromagnetische Strahlungsquelle (102) montiert ist, und einen Detektorträger (118), auf dem der elektromagnetische Strahlungsdetektor (106) montiert ist;
• wobei der elektromagnetische Strahlungsdetektor (106) zum Detektieren elektromagnetischer Strahlung an seiner oberen Hauptoberfläche (108) konfiguriert ist;
• **dadurch gekennzeichnet, dass** zumindest ein Teil von zumindest einem von dem Quellenträger (116) und dem Detektorträger (118) geneigt ist, so dass die elektromagnetische Strahlungsquelle (102) und der elektromagnetische Strahlungsdetektor (106) in Bezug zueinander geneigt sind.

2. Der Optokoppler (100) gemäß Anspruch 1, wobei die elektromagnetische Strahlungsquelle (102) eine Laserdiode ist.

3. Der Optokoppler (100) gemäß Anspruch 1 oder 2, wobei der elektromagnetische Strahlungsdetektor (106) eine Fotodiode ist.

4. Der Optokoppler (100) gemäß einem der Ansprüche 1 bis 3, wobei die elektromagnetische Strahlungsquelle (102) und der elektromagnetische Strahlungsdetektor (106) elektrisch voneinander entkoppelt sind.

5. Der Optokoppler (100) gemäß einem der Ansprüche 1 bis 4, wobei die elektromagnetische Strahlungsquelle (102) zum Emittieren elektromagnetischer Strahlung im Wesentlichen nur an ihrer Seitenwand (104) konfiguriert ist.

6. Der Optokoppler (100) gemäß einem der Ansprüche 1 bis 5, aufweisend eine Steuereinheit (110), die mit dem elektromagnetischen Strahlungsdetektor (106) gekoppelt ist und zum Ausführen einer Steueraufgabe, insbesondere einer Schaltaufgabe, basierend auf der detektierten elektromagnetischen Strahlung konfiguriert ist.

7. Der Optokoppler (100) gemäß einem der Ansprüche 1 bis 6, aufweisend eine optisch transparente Einkapselung (112), insbesondere ein transparentes Gel, in die zumindest ein Teil der elektromagnetischen Strahlungsquelle (102) und zumindest ein Teil des elektromagnetischen Strahlungsdetektors (106) eingebettet sind.

8. Der Optokoppler (100) gemäß einem der Ansprüche 1 bis 7, aufweisend einen Gehäusekörper (130), der zumindest einen Teil der elektromagnetischen Strahlungsquelle (102) und zumindest einen Teil des elektromagnetischen Strahlungsdetektors (106) umgibt und eine reflektierende Innenoberfläche (114) aufweist, die zum Reflektieren zumindest eines Teils, insbesondere zum Totalreflektieren, elektromagnetischer Strahlung, die von der elektromagnetischen Strahlungsquelle (102) emittiert wird, konfiguriert ist, wobei die reflektierende Innenoberfläche (114) insbesondere zum Reflektieren und Lenken zumindest eines Teils der elektromagnetischen Strahlung auf den elektromagnetischen Strahlungsdetektor (106) konfiguriert ist.

9. Der Optokoppler (100) gemäß einem der Ansprüche 1 bis 8, aufweisend zumindest eines der folgenden Merkmale:
• wobei die elektromagnetische Strahlungsquelle (102) zum Emittieren von rotem Licht, insbesondere ausschließlich rotem Licht, konfiguriert ist;
• wobei der Optokoppler (100) als Relais, insbesondere Festkörperrelais, konfiguriert ist;
• wobei die elektromagnetische Strahlungsquelle (102) zum Emittieren von zumindest 60%, insbesondere zumindest 80%, einer Intensität der emittierten elektromagnetischen Strahlung an ihrer Seitenwand (104) innerhalb eines Winkelbereichs (α) von nicht mehr als 45°, insbesondere von nicht mehr als 30°, um eine Achse senkrecht zu der Seitenwand (104) konfiguriert ist;
• wobei die seitenemittierende elektromagnetische Strahlungsquelle (102) zum Emittieren von im Wesentlichen monochromatischer elektromagnetischer Strahlung konfiguriert ist, und der elektromagnetische Strahlungsdetektor (106) zum Detektieren von im Wesentlichen nur innerhalb eines schmalen Wellenlängenbands um eine Wellenlänge der emittierten im Wesentlichen monochromatischen elektromagnetischen Strahlung konfiguriert ist;
• wobei die seitenemittierende elektromagnetische Strahlungsquelle (102) und der elektromagnetische Strahlungsdetektor (106) nebeneinander angeordnet sind.

10. Der Optokoppler (100) gemäß einem der Ansprüche 1 bis 9, aufweisend zumindest eines der folgenden Merkmale:
• wobei der Quellenträger (116) und der Detektorträger (118) Leiterrahmen sind oder getrennte Sektionen eines gemeinsamen Leiterrahmens sind;
• wobei der Quellenträger (116) und der Detektorträger (118) auf der gleichen vertikalen Ebene (120) angeordnet sind;
• wobei der Quellenträger (116) auf einer höheren vertikalen Ebene (120) als der Detektorträger (118) angeordnet ist, so dass die lichtemittierende Seitenwand (104) auf einer höheren vertikalen Ebene (120) als eine Seitenwand des elektromagnetischen Strahlungsdetektors (106) angeordnet ist.

11. Der Optokoppler (100) gemäß einem der Ansprüche 1 bis 10, aufweisend einen Deflektor (122), der zum Ablenken zumindest eines Teils der emittierten elektromagnetischen Strahlung auf den elektromagnetischen Strahlungsdetektor (106) angeordnet ist.

12. Der Optokoppler (100) gemäß Anspruch 11, aufweisend zumindest eines der folgenden Merkmale:
• der Deflektor (122) ist auf einem Detektorträger (118) montiert, auf dem der elektromagnetische Strahlungsdetektor (106) montiert ist;
• der elektromagnetische Strahlungsdetektor (106) ist zwischen der elektromagnetischen Strahlungsquelle (102) und dem Deflektor (122) angeordnet;
• der Deflektor (122) weist eine Ablenkoberfläche (166) auf, die mit einem Ablenkwinkel (β), insbesondere in einem Bereich zwischen 30° und 60°, in Bezug auf einfallende elektromagnetische Strahlung, die auf den elektromagnetischen Strahlungsdetektor (106) abgelenkt werden soll, abgewinkelt ist;
• wobei der Deflektor (122) ein lötbares Material aufweist oder daraus besteht, insbesondere auf einen Detektorträger (118), insbesondere einen Leiterrahmen, gelötet ist, auf dem der elektromagnetische Strahlungsdetektor (106) montiert ist.

13. Ein Verfahren zum Betreiben eines Optokopplers (100), wobei das Verfahren aufweist:
• Emittieren elektromagnetischer Strahlung an einer Seitenwand (104) einer seitenemittierenden elektromagnetischen Strahlungsquelle (102); und
• Detektieren zumindest eines Teils der emittierten elektromagnetischen Strahlung durch einen plattenförmigen elektromagnetischen Strahlungsdetektor (106);
• wobei der Optokoppler (100) einen Quellenträger (116) aufweist, auf dem die elektromagnetische Strahlungsquelle (102) montiert ist, und einen Detektorträger (118) aufweist, auf dem der elektromagnetische Strahlungsdetektor (106) montiert ist;
• wobei der elektromagnetische Strahlungsdetektor (106) zum Detektieren elektromagnetischer Strahlung an seiner oberen Hauptoberfläche (108) konfiguriert ist;
• **dadurch gekennzeichnet, dass** zumindest ein Teil von zumindest einem von dem Quellenträger (116) und dem Detektorträger (118) geneigt ist, so dass die elektromagnetische Strahlungsquelle (102) und der elektromagnetische Strahlungsdetektor (106) in Bezug zueinander geneigt sind.

## Revendications

1. Un optocoupleur (100), qui comprend :
• une source (102) du rayonnement électromagnétique à émission latérale pou émettre du rayonnement électromagnétique à sa paroi (104) latérale ; et
• un détecteur (106) du rayonnement électromagnétique en forme de plaque pour détecter au moins une partie du rayonnement électromagnétique émis ;
• un support (116) de source, sur lequel la source (102) du rayonnement électromagnétique est montée, et un support (118) de détecteur, sur lequel le détecteur (106) du rayonnement électromagnétique est monté ;
• dans lequel le détecteur (106) du rayonnement électromagnétique est configuré pour détecter du rayonnement électromagnétique à sa surface (108) principale supérieure,
• **caractérisé en ce qu'**
au moins une partie d'au moins l'un du support (116) de la
source et du support (118) du détecteur est en biais, de manière à ce que la source (102) du rayonnement électromagnétique et le détecteur (106) du rayonnement électromagnétique soient inclinés l'un par rapport à l'autre.

2. L'optocoupleur (100) suivant la revendication 1, dans lequel la source (102) du rayonnement électromagnétique est une diode laser.

3. L'optocoupleur (100) suivant la revendication 1 ou 2, dans lequel le détecteur (106) du rayonnement électromagnétique est une photodiode.

4. L'optocoupleur (100) suivant l'une quelconque des revendications 1 à 3, dans lequel la source (102) du rayonnement électromagnétique et le détecteur (106) du rayonnement électromagnétique sont découplés électriquement l'un de l'autre.

5. L'optocoupleur (100) suivant l'une quelconque des revendications 1 à 4, dans lequel la source (102) du rayonnement électromagnétique est configurée pour émettre du rayonnement électromagnétique sensiblement seulement à sa paroi (104) latérale.

6. L'optocoupleur (100) suivant l'une quelconque des revendications 1 à 5, comprenant une unité (110) de commande couplée au détecteur (106) du rayonnement électromagnétique et configurée pour effectuer une tâche de commande, en particulier une tâche de commutation, sur la base du rayonnement électromagnétique détecté.

7. L'optocoupleur (100) suivant l'une quelconque des revendications 1 à 6, comprenant un enrobant (112) transparent optiquement, en particulier un gel transparent, dans lequel au moins une partie de la source (102) du rayonnement électromagnétique et au moins une partie du détecteur (106) du rayonnement électromagnétique sont enrobées.

8. L'optocoupleur (100) suivant l'une quelconque des revendications 1 à 7, comprenant un corps (130) de boîtier entourant au moins une partie de la source (102) de rayonnement électromagnétique et au moins une partie du détecteur (106) du rayonnement électromagnétique et ayant une surface (114) intérieure réfléchissante configurée pour réfléchir au moins une partie, en particulier pour réfléchir totalement, du rayonnement électromagnétique émis par la source (102) du rayonnement électromagnétique, dans lequel la surface (114) intérieure réfléchissante est configurée en particulier pour réfléchir et diriger au moins une partie du rayonnement électromagnétique sur le détecteur (106) du rayonnement électromagnétique.

9. L'optocoupleur (100) suivant l'une quelconque des revendications 1 à 8, comprenant au moins l'une des caractéristiques suivantes :
• dans lequel la source (102) du rayonnement électromagnétique est configurée pour émettre de la lumière rouge, en particulier exclusivement de la lumière rouge ;
• l'optocoupleur (100) est configuré en relais, en particulier en relais à semiconducteur ;
• dans lequel la source (102) du rayonnement électromagnétique est configurée pour émettre au moins 60 %, en particulier au moins 80 %, d'une intensité du rayonnement électromagnétique émis à sa paroi (104) latérale dans une plage (α) angulaire de pas plus de 45°, en particulier de pas plus de 30°, autour d'un axe perpendiculaire à la paroi (104) latérale ;
• dans lequel la source (102) du rayonnement électromagnétique à émission latérale est configurée pour émettre du rayonnement électromagnétique sensiblement monochromatique, et le détecteur (106) du rayonnement électromagnétique est configuré pour détecter sensiblement seulement dans une bande de longueur d'onde étroite autour d'une longueur d'onde dudit rayonnement électromagnétique sensiblement monochromatique émis ;
• dans lequel la source (102) du rayonnement électromagnétique à émission latérale et le détecteur (106) du rayonnement électromagnétique sont disposés côte à côte.

10. L'optocoupleur (100) suivant l'une quelconque des revendications 1 à 9, comprenant au moins l'une des caractéristiques suivantes :
• dans lequel le support (116) de la source et le support (118) du détecteur sont des grilles de connexion ou sont des parties distinctes d'une grille connexion commune ;
• dans lequel le support (116) de la source et le support (118) du détecteur sont disposés au même niveau (120) vertical ;
• dans lequel le support (116) de la source est disposé à un niveau (120) vertical plus haut que le support (118) du détecteur de manière à ce que la paroi (104) latérale émettant de la lumière soit disposée à un niveau (120) vertical plus haut qu'une paroi latérale du détecteur (106) du rayonnement électromagnétique.

11. L'optocoupleur (100) suivant l'une quelconque des revendications 1 à 10, comprenant un déflecteur (122) pour dévier au moins une partie du rayonnement électromagnétique émis sur le détecteur (106) du rayonnement électromagnétique.

12. L'optocoupleur (100) suivant la revendication 11, comprenant au moins l'une des caractéristiques suivantes :
• le déflecteur (122) est monté sur un support (118) de détecteur sur lequel le détecteur (106) du rayonnement électromagnétique est monté ;
• le détecteur (106) du rayonnement électromagnétique est disposé entre la source (102) du rayonnement électromagnétique et le déflecteur (122) ;
• le déflecteur (122) a une surface (166) de déflection, qui fait un angle (β) de déflection, en particulier dans une plage comprise entre 30° et 60°, par rapport à du rayonnement électromagnétique incident à dévier sur le détecteur (106) du rayonnement électromagnétique ;
• dans lequel le déflecteur (122) comprend ou consiste en un matériau pouvant être soudé, en étant en particulier soudé sur le support (118) du détecteur, plus particulièrement sur une grille de connexion, sur lequel le détecteur (106) du rayonnement électromagnétique est monté.

13. Un procédé pour faire fonctionner un optocoupleur (100), dans lequel le procédé comprend :
• émettre du rayonnement électromagnétique à une paroi (104) latérale d'une source (102) du rayonnement électromagnétique à émission latérale ; et
• détecter au moins une partie du rayonnement électromagnétique émis par un détecteur (106) du rayonnement électromagnétique en forme de plaque ;
• dans lequel l'optocoupleur (100) comprend un support (116) de la source, sur lequel la source (102) du rayonnement électromagnétique est montée, et comprend un support (118) du détecteur, sur lequel le détecteur (106) du rayonnement électromagnétique est monté ;
• dans lequel le détecteur (106) du rayonnement électromagnétique est configuré pour détecter du rayonnement électromagnétique à sa surface (108) principale supérieure ;
• **caractérisé en ce qu'**
au moins une partie d'au moins l'un du support (116) de la
source et du support (118) du détecteur est en biais, de manière à ce que la source (102) du rayonnement électromagnétique et le détecteur (106) du rayonnement électromagnétique soient inclinés l'un par rapport à l'autre.
